# EUROPÄISCHE PATENTSCHRIFT

(11) **EP 2 360 830 B1**
(45) Veröffentlichungstag und Bekanntmachung des Hinweises auf die Patenterteilung: **19.09.2012**
(21) Anmeldenummer: 10000966.1
(22) Anmeldetag: 01.02.2010
(51) Int. Cl.: H02P 5/00, G05B 17/02, G01L 3/16, G01R 31/34

(54) **Verfahren und Vorrichtung zur Simulation eines elektromechanischen Wandlers**
Method and device for simulating an electromechanical converter
Procédé et dispositif de simulation d'un convertisseur électromécanique

(43) Veröffentlichungstag der Anmeldung: 24.08.2011
(73) Patentinhaber: AumoSoft GmbH, 19061 Schwerin (DE)
(72) Erfinder: Kleinfeld, Michael, 19061 Schwerin (DE)
(74) Vertreter: Rossmann, Siegfried

(56) Entgegenhaltungen:
- DE-A1-102008 057 167
- US-A- 4 383 439
- US-A- 5 436 784
- XINGJIAN WANG ET AL: "Electrical load simulator based on velocity-loop compensation and improved fuzzy-PID" INDUSTRIAL ELECTRONICS, 2009. ISIE 2009. IEEE INTERNATIONAL SYMPOSIUM ON, IEEE, PISCATAWAY, NJ, USA, 5. Juli 2009 (2009-07-05), Seiten 238-243, XP031518461 ISBN: 978-1-4244-4347-5
- DYMOND J H ET AL: "Locked-Rotor and Acceleration Testing of Large Induction Machines-Methods, Problems, and Interpretation of the Results" IEEE TRANSACTIONS ON INDUSTRY APPLICATIONS, IEEE SERVICE CENTER, PISCATAWAY, NJ, US, Bd. 36, Nr. 4, 1. Juli 2000 (2000-07-01), XP011022795 ISSN: 0093-9994
- KACZMAREK R ET AL: "Magnetic losses simulation in PM SM drive by FE: Harmonic superposition by method of locked rotor" ELECTRICAL POWER QUALITY AND UTILISATION, 2007. EPQU 2007. 9TH INTERNATIONAL CONFERENCE ON, IEEE, PISCATAWAY, NJ, USA, 9. Oktober 2007 (2007-10-09), Seiten 1-4, XP031225904 ISBN: 978-84-690-9441-9

## Beschreibung

Die Erfindung bezieht sich auf ein Verfahren zur Simulation eines elektromechanischen Wandlers nach dem Oberbegriff des Anspruchs 1 und eine dazugehörige Vorrichtung nach dem Oberbegriff des Anspruchs 5.

Derartige Verfahren und Vorrichtungen zur Simulation von elektromechanischen Wandlern werden insbesondere zur Simulation von Elektromotoren und Generatoren, z.B. in der Automobilindustrie als Prüfstand von Elektromotoren und Generatoren sowie deren Steuerelemente eingesetzt.

In der Automobilindustrie gewinnen elektrische Antriebe, insbesondere in Elektro- oder Hybridautos zunehmend an Bedeutung. Diese elektrischen Antriebe bestehen im Wesentlichen aus einem Akkumulator, einem Umrichter, einem Elektromotor und einer Getriebeeinheit. Vor dem Einbau in Elektro- oder Hybridautos müssen diese elektrischen Antriebe erprobt werden, wofür es zwei prinzipielle Vorgehensweisen gibt.

Mit der ersten Vorgehensweise wird der komplette elektrische Antrieb zusammen mit dem Elektromotor und der Getriebeeinheit erprobt. In der zweiten Vorgehensweise wird der komplette elektrische Antrieb zusammen mit dem Elektromotor und der Getriebeeinheit simuliert.

Die erste Vorgehensweise ist sehr realitätsnah und liefert deshalb Ergebnisse mit einer sehr guten Übereinstimmung mit der zu realisierenden Anwendung. Dafür ist sie jedoch sehr zeitaufwändig und teuer.

Dagegen ist die zweite Vorgehensweise billig. Allerdings hängt die Qualität der Ergebnisse sehr von der Qualität der Simulationsmodelle ab. Zudem werden Nebeneffekte, die die spätere Anwendung entscheidend stören könnten, in vielen Fällen nicht entdeckt.

Die Entwicklung von elektrischen Antrieben steht unter dem Druck immer komplexerer Zusammenhänge bei gleichzeitig immer kürzeren Entwicklungszeiten. Gleichsam wachsen die Anforderungen an den Umfang der Erprobungen.

Dazu werden in der Praxis automatisierte Test- und Prüfstände für die Testfallgenerierung, die Prüfstandkonfiguration, die Testdurchführung und für die Testauswertung eingesetzt. Weitere Anforderungen bestehen in der Wiederverwendbarkeit und der Austauschbarkeit von Testfällen. Ebenfalls wird eine weitestgehende Unabhängigkeit der Testfälle für unterschiedliche Anwendungsvarianten gefordert. Dadurch findet eine Verlagerung des Anteils der Entwicklungsleistung von den Steuergeräten hin zu deren Testsystemen statt. Die Wirtschaftlichkeit erfordert "Testhäuser" mit einer 24 h bis 7 d Auslastung. Diese Anforderungen führten dazu, dass eine standardisierte Schnittstelle in der Automobilindustrie für Testsysteme beschlossen worden ist.

Dazu zählt der HIL (engl.: Hardware-in-the-loop) Standard, der einen Mittelweg zu den eingangs genannten Vorgehensweisen ist. Das ist ein wichtiges Verfahren, das weiter an Bedeutung gewinnen wird, weil damit ein Industriestandart für den Einsatz von HIL-Testsystemen in der Automobilindustrie existiert. Bei HIL- Testsystemen wird mindestens eine reale Komponente an einem Simulator angeschlossen.

So werden HIL- Testsysteme, ausgehend von dem eingangs vorgestellten elektrischen Antrieb, der im Wesentlichen aus Akkumulator, Umrichter, Elektromotor und Getriebeeinheit besteht, nach der Schnittstelle zwischen realen Komponenten und Simulation unterschieden.

In einer ersten Variante des HIL- Testsystems ist diese Schnittstelle zwischen Umrichter und Motor angeordnet, wobei der Akkumulator und der Umrichter reale Komponenten sind. Der Motor und die Getriebeeinheit hingegen werden durch einen zweiten zum Nachbilden des Lastverhaltens des Elektromotors mit Getriebeeinheit dienenden Umrichter simuliert.

So ist aus der DE 10 2005 048 464 A1 ein Verfahren zur Simulation der Wirkung wenigsten einer elektrischen/ elektronischen Last, insbesondere einer induktiven Last an einem Anschluss eines Steuergerätes, insbesondere eines Kfz-Steuergerätes bekannt, bei dem ein theoretisch durch die simulierte Last an wenigstens einem Anschluss fließender Strom dadurch real nachgebildet wird, dass mittels einer mit dem wenigstens einen Anschluss verbundenen Stromeinheit ein Strom dem Steuergerät entnommen oder aufgeprägt wird. Von Nachteil ist aber, dass kein realer Elektromotor verwendet wird, wodurch eine Testung des Lastverhaltens des Elektromotors, insbesondere im Grenzbereich nicht realisiert werden kann. Damit sind die erhaltenen Testergebnisse unvollständig.

Deshalb ist in einer zweiten Variante des HIL- Testsystems die Schnittstelle zwischen Elektromotor und Getriebeeinheit angeordnet, wobei Elektromotor und Getriebeeinheit über eine Welle miteinander gekoppelt sind und die Schnittstelle durch diese Welle geht. Hierbei sind der Akkumulator, der Umrichter und der Elektromotor die realen Komponenten. Die Getriebeeinheit hingegen wird durch einen zweiten, zum Nachbilden des Lastverhaltens des Getriebes dienenden Elektromotor simuliert.

Von Nachteil ist, dass der Elektromotor bei Testung des Lastverhaltens im Grenzbereich häufig zerstört wird.

Auch ist aus der DE 10 2007 048 770 A1 ein weiteres Verfahren zur Simulation der Wirkung wenigsten einer elektrischen/ elektronischen Last, insbesondere einer induktiven Last an einem Anschluss eines Steuergerätes bekannt, bei dem eine Drehfeldmaschine über drei Wicklungsstränge mit jeweils einer Wicklungsinduktion, Wicklungswiderstand und Spannung eines EMK-Reglers simuliert wird, wobei das Stellsignal des Reglers jeweils auf eine Leistungsstufe geht, mit der die Gegenspannung für jeden Wicklungsstrang separat gebildet wird und die Regelspannungen jeweils zum Abgleich der aus Wicklungswiderstand und Wicklungsinduktion resultierenden Ist-Spannungswerte und nach den Soll-Spannungswerten geregelt werden. Dabei werden diese Soll-Spannungswerte aus einem Motormodell berechnet.

Hierbei ist aber von Nachteil, dass mit diesem Motormodell Parameter wie Luftspaltmoment berechnet werden und somit nicht den Werten eines realen Elektromotors entsprechen. Zudem werden die Spannungen in den Wicklungssträngen durch eine Gegenspannung kompensiert, so dass reale elektrische Wechselfelder nicht berücksichtigt werden.

Der Erfindung liegt daher die Aufgabe zu Grunde, ein gattungsgemäßes Verfahren zur Simulation eines elektromechanischen Wandlers sowie eine dazugehörige Vorrichtungen zu entwickeln, dass eine Testung des Lastverhaltens des elektromechanischen Wandlers, insbesondere des Grenzbereich des Lastverhaltens ermöglicht, wobei der elektromechanische Wandler nicht zerstört wird und bei dem reale elektromagnetische Wechselfelder berücksichtigt werden.

Diese Aufgabe wird verfahrensseitig durch die kennzeichnenden Merkmale des Anspruchs 1 und vorrichtungsseitig durch die kennzeichnenden Merkmale des Anspruchs 5 gelöst. Zweckdienliche Ausgestaltungen ergeben sich aus den Unteransprüchen 2 bis 4 und 6 bis 10.

Das neue Verfahren zur Simulation eines elektromechanischen Wandlers sowie die dazugehörige Vorrichtung beseitigen die genannten Nachteile des Standes der Technik. Vorteilhaft bei der Anwendung des neuen Verfahrens zur Simulation eines elektromechanischen Wandler ist es, dass das Verhalten eines realen Rotors simuliert wird, indem ein Rotor an seiner Rotation gehindert wird und dabei unterschiedliche Drehzahlen und unterschiedliche Lastfälle simuliert werden sowie das Drehmoment des Rotors ermittelt wird. Dadurch wird das Verhalten des realen Rotors durch eine synthetische Anordnung ersetzt, in dem ein Rotor durch einen Umrichter gespeist wird. Zudem ist dieses Verfahren auch zeitsparend, weil ein Erhöhen oder Verringern der Rotordrehzahl schneller erfolgt als bei einem realen Rotor. Auch sind dadurch Versuche in Zeitraffer möglich. Von Vorteil ist es dann, wenn unterschiedliche Drehzahlen simuliert werden, weil dies in einfacher und genauer Weise durch:
- ein Ändern der Stromstärke der an den elektrischen Wicklungen des Rotors angelegten Wechselspannung mittels einer Drehzahlreglung,
- ein Ändern der Stromstärke der an den elektrischen Wicklungen des Stators angelegten Wechselspannung mittels einer EMK-Reglung oder
- eine Erregung eines Stators, wobei die Frequenz und die Amplitude dieser Erregung des Stators als Führungsgröße für eine Drehzahlregelung des Rotors dienen, ermöglicht wird.

So wird im Asynchronbetrieb, während einer Änderung der Erregung an den Wicklungen des Stators eine Drehmoment-Drehzahl-Kennlinie bestimmt, wobei ein Lastmoment dem Rotor über eine Datenschnittstelle vorgegeben wird. Auf dieser Kennlinie stellt sich eine Drehzahl ein, welche bei der Simulation über die Drehzahlreglung durch die Stromstärke an den Wicklungen des Rotors simuliert wird.

Ebenso wird im Synchronbetrieb während einer Änderung der Erregung an den Wicklungen des Stators eine Drehmoment-Lastwinkel-Kennlinie bestimmt, wobei ein Lastmoment dem Rotor über eine Datenschnittstelle vorgegeben wird. Auf dieser Kennlinie stellt sich ein Lastwinkel ein, welche bei der Simulation durch unterschiedliche Phasenverschiebungen simuliert wird.

Auch ist es von Vorteil, wenn der Rotor mit einer Drehmomentenmessung gekoppelt ist, weil dadurch ein Zusammenhang zwischen Drehzahl und Drehmoment wie bei einem realen elektromechanischen Wandlers hergestellt wird.

Von Vorteil ist es dann, wenn der Rotor mit einem Gleich- oder Wechselstrom gespeist wird, weil der Rotor so ein elektromagnetisches Feld gegenüber dem Stator aufbaut, wie es dem eines Rotors eines realen Gleich- bzw. Wechselstrommotors entspricht.

Auch ist es von Vorteil, wenn die unterschiedlichen Lastfälle durch eine Phasenverschiebung der Frequenz der an den elektrischen Wicklungen des Rotors anliegenden Wechselspannung realisiert werden, weil dadurch Lastwechsel schnell simuliert werden können.

Für die Simulation eines Wechselstrommotors ist es vorteilhaft, den Rotor mit der Frequenz des Drehfeldes des Stators zu speisen. Im Asynchronbetrieb wird die Drehzahl dann durch die Amplitude der Erregung simuliert. Im Synchronbetrieb, bei dem die Drehzahl fest an die Frequenz des Drehfeldes des Stators unter Berücksichtigung der Polpaarzahl gebunden ist, wird der Rotor mit einer konstanten Amplitude erregt.

Im Asynchronbetrieb beeinflusst das Lastmoment die Drehzahl, die durch die Amplitude simuliert wird, und bewirkt eine Änderung des Antriebsmoments, welches gemessen wird. Im Synchronbetrieb beeinflusst dagegen das Lastmoment den Lastwinkel, der durch eine elektronische Phasenverschiebung zwischen der Erregung des Rotors und der Erregung des Stators simuliert wird, und bewirkt ebenfalls eine Änderung des Antriebsmoments, welches gemessen wird.

Bei der Simulation des Asynchronbetriebs eines Wechselstrommotors mit Käfigläufer ist die Frequenz der induzierten Spannung im Rotor, gleich der Frequenz des den Rotor überstreichenden Drehfeldes des Stator. Der Rotor wird während des gesamten Simulationslaufes, der insbesondere das Beschleunigen und das Bremsen umfasst, mit der Frequenz der Erregung des Stators erregt. Die Amplitude der Erregung am Rotor ist ein Maß für die Drehzahl. Beim Gegenstrombremsen, bei dem das Drehfeld des Stators entgegengesetzt zur Drehrichtung des Rotors ist, ist im Nulldurchgang der Betrag der Amplitude der Erregung des Rotors äquivalent zum Anlaufdrehmoment unter Berücksichtigung der Haftreibung beim stehenden Rotor. Nach dem Nulldurchgang bei gleichbleibender Erregung am Stator zeigen Drehrichtung und Drehmoment wieder in die gleiche Richtung.

Es ist vorteilhaft, wenn bei den Berechnungen der Induktivitäten berücksichtigt wird, dass beim Gegenstrombremsen die induzierte Spannung im Rotor eines originalen elektromechanischen Wandlers eine höhere Frequenz gegenüber der Frequenz der Erregung des Rotor besitzt und im Normalbetrieb, insbesondere beim Beschleunigen, die induzierte Spannung im Rotor eines originalen elektromechanischen Wandlers eine niedrigere Frequenz gegenüber der Frequenz der Erregung des Rotor besitzt.

Ebenso ist es vorteilhaft, wenn der Betrag der Energie, die beim originalen elektromechanischen Wandler aufgrund der Bewegung des Rotors für Haft-/Gleitreihung, Erwärmung, Ummagnetisierung und Beschleunigung aufgewandt wird, in der EMK-Regelung berücksichtigt wird.

Dabei ist es von Vorteil, wenn das Drehmoment des elektromechanischen Wandler gleich dem Antriebsdrehmoment eines originalen elektromechanischen Wandlers ist.

Vorteilhaft bei der Anwendung der neuen Vorrichtung zur Simulation eines elektromechanischen Wandlers ist es, dass der Rotor durch eine Haltevorrichtung gehalten und an seiner Rotation gehindert wird. Dabei ist die Haltevorrichtung entweder ein Haltearm, durch den der Rotor derart gehalten wird, dass der Rotor gegenüber dem Stator starr und nicht drehbar ist, wobei der Haltearm direkt oder über einen Drucksensor mit dem Gehäuse verbunden ist, oder die Haltevorrichtung eine Spiralfeder oder ein Drehmomentsensor ist, durch die der Rotor gegenüber dem Stator schwenkbar ist.

Von Vorteil ist auch, wenn die Frequenz, der an den elektrischen Wicklungen des Rotors anliegenden Wechselspannung gleich der Frequenz der Wechselspannung, der Erregung am Stator ist, weil dadurch der Lauf eines Asynchronmotors oder eines Synchronmotors simuliert werden kann. In dieser Weise kann auch ein Wechselstrommotor, der mittels eines Kurzschlussläufers annähernd auf eine synchrone Drehzahl gebracht wird und dann zum Erreichen des synchronen Betriebes den Kurzschlusskäfigläufer abwirft, von der neuen Vorrichtung simuliert werden.

Von Vorteil ist auch, wenn für eine Lastfallsteuerung der Rotor mit einer Einrichtung zur Einstellung unterschiedlicher Lastwinkel gekoppelt ist, wobei ein Lastwinkel der auf die Drehachse des Rotors bezogene Winkel zwischen den elektrischen Wicklungen des Stators und den elektrischen Wicklungen des Rotors ist, oder wenn für die Lastfallsteuerung der Rotor mit einer Einrichtung zur Einstellung einer Phasenverschiebung der Frequenz der an den elektrischen Wicklungen des Rotors anliegenden Wechselspannung gekoppelt ist.

Das neue Verfahren zur Simulation eines elektromechanischen Wandlers sowie die dazugehörige Vorrichtung sollen nun an zwei Ausführungsbeispielen erläutert werden. Dazu zeigen:
- Fig. 1:: Schematische Darstellung der Vorrichtung zur Simulation eines elektrome-chanischen Wandlers in einem ersten Ausführungsbeispiel,
- Fig. 2:: Schematische Darstellung der Vorrichtung zur Simulation eines elektrome-chanischen Wandlers in einer Alternative des ersten Ausführungsbeispiels,
- Fig. 3:: Schematische Darstellung einer EMK-Reglung der Vorrichtung zur Simulation eines elektromechanischen Wandlers in der Alternative des ersten Ausführungsbeispiels,
- Fig. 4:: Schematische Darstellung einer Drehzahlreglung der Vorrichtung zur Simulation eines elektromechanischen Wandlers in der Alternative des ersten Ausführungsbeispiels,
- Fig. 5:: Schematische Darstellung eines Lastwinkels bei der Vorrichtung zur Simulation eines elektromechanischen Wandlers in der Alternative des ersten Ausführungsbeispiels,
- Fig. 6:: Schematische Darstellung der Vorrichtung zur Simulation eines elektrome-chanischen Wandlers in einem zweiten Ausführungsbeispiel,
- Fig. 7:: Schematische Darstellung der Vorrichtung zur Simulation eines elektrome-chanischen Wandlers in einer Alternative des zweiten Ausführungsbeispiels und
- Fig. 8:: Simulationsablauf eines Rotors nach dem zweiten Ausführungsbeispiel in einem Drehwinkel von 0° bis 180° im Vergleich zu einem originalen Gleichstromrotor.

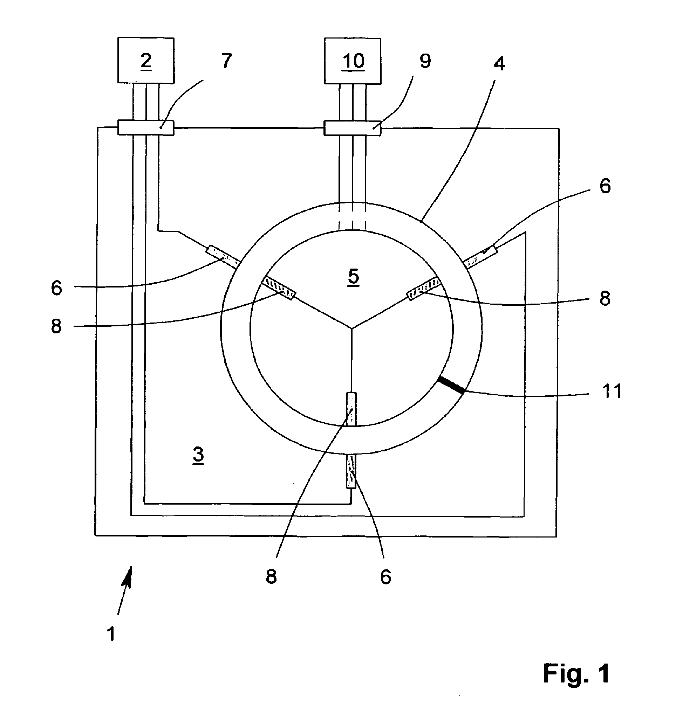

Die neue Vorrichtung zur Simulation eines elektromechanischen Wandlers besteht in einem ersten Ausführungsbeispiel gemäß der **Fig. 1** im Wesentlichen aus einem elektromechanischen Wandler 1 und einem Umrichter 2, wobei der elektromechanische Wandler 1 wiederum ein Gehäuse 3 mit einem in dem Gehäuse 3 angeordneten Stator 4 und einem Rotor 5 besitzt.

Der Stator 4 weist drei über seinen Umfang in einem Winkel von 120° verteilte elektrische Wicklungen 6 auf, dessen elektrische Leitungen in einem auf dem Gehäuse 3 angeordneten Anschlusskasten 7 münden. Der Rotor 5 des elektromechanischen Wandlers 1 besitzt drei, um jeweils 120° zueinander versetzt angeordnete elektrische Wicklungen 8, die über eine Anschlussleiste 9 mit einem weiteren Umrichter 10 elektrisch verbunden sind. Zudem ist der Rotor 5 über eine Haltearm 11 derart mit dem Stator 4 des elektromechanischen Wandlers 1 verbunden, dass der Rotor 5 gegenüber dem Stator 4 starr gelagert ist. Dadurch ist der Rotor 5 des elektromechanischen Wandlers 1 nicht drehbar gelagert.

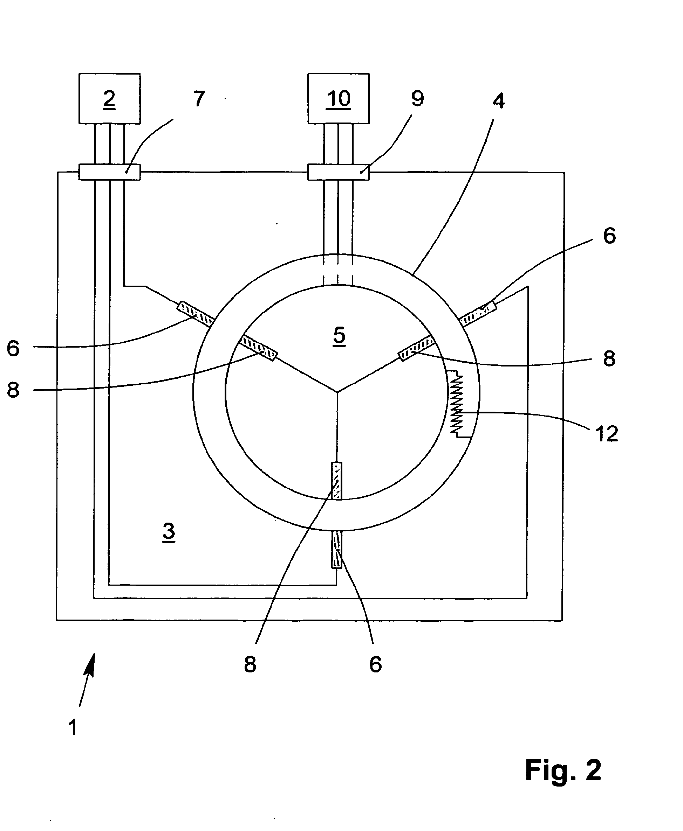

Alternativ ist gemäß der **Fig. 2** der Haltearm 11 durch eine Spiralfeder 12 ersetzt, so dass der Rotor 5 des elektromechanischen Wandlers 1 sich verdrehen kann. Dabei wird durch die Spiralfeder 12 das durch ein elektromagnetisches Wechselfeld erzeugte und auf den Rotor 5 wirkende Drehmoment kompensiert, wobei die Verdrehung des Rotors 5 ein Maß für das durch das elektromagnetische Wechselfeld erzeugte und auf den Rotor 5 wirkende Drehmoment ist.

Die Wirkungsweise der neuen Vorrichtung zur Simulation eines elektromechanischen Wandlers nach dem ersten Ausführungsbeispiel soll an der alternativen Ausführung gemäß der **Fig. 2** erläutert werden. Dabei unterscheidet sich die Wirkungsweise der neuen Vorrichtung in der Simulation eines Wechselstrommotors und eines Generators, wobei die Simulation eines Wechselstrommotors wiederum in Asynchronmotor und Synchronmotor unterschieden wird.

Wird zur Simulation eines Wechselstrommotors an dem elektromechanischen Wandler 1 ein Dreiphasenwechselstrom angelegt, dann führt diese Stromart in drei getrennten elektrischen Wicklungen 6 jeweils zu einer eigenen periodisch wechselnden Spannung. Dabei sind die zeitlichen Abläufe der periodisch wechselnden Spannungen untereinander um jeweils 120° versetzt. An den elektrischen Wicklungen 6 des Stators 4 wird jeweils ein elektromagnetisches Feld erzeugt, dessen zeitlicher Ablauf genauso wie der Spannungsverlauf gegenüber den elektromagnetischen Feldern der anderen elektrischen Wicklungen 6 um eine Drittelperiode versetzt ist. Durch die durch den Stator 4 in einem Kreis zueinander angeordneten elektrischen Wicklungen 6 ergibt sich ein summiertes elektromagnetisches Feld, das von gleichbleibender Größe ist, sich aber in seiner Richtung exakt im Einklang mit der Frequenz bzw. der Periodenwiederholung des Drehstromes fortlaufend ändert. Dieses summierte elektromagnetische Feld verläuft um die, im Stator 4 in einem Kreis zueinander angeordneten elektrischen Wicklungen 6 exakt mit der Geschwindigkeit, die durch die Frequenz vorgegeben ist. So dreht sich beispielsweise das elektromagnetische Feld bei einem Dreiphasenwechselstrom mit 50 Hz ebenfalls 50-mal in der Sekunde um sich selbst. Durch dieses rotierende elektromagnetische Feld wirkt ein Drehmoment auf den Rotor 5. Die drei, um jeweils 120° versetzten elektrischen Wicklungen 8 des Rotors 5 sind mit einer weiteren Wechselspannung beaufschlagt, durch die ebenfalls ein elektromagnetisches Feld erzeugt wird. Dabei sind die Frequenzen der an den elektrischen Wicklungen 6 des Stators 4 und an den elektrischen Wicklungen 8 des Rotors 5 angelegten Wechselspannungen gleich.

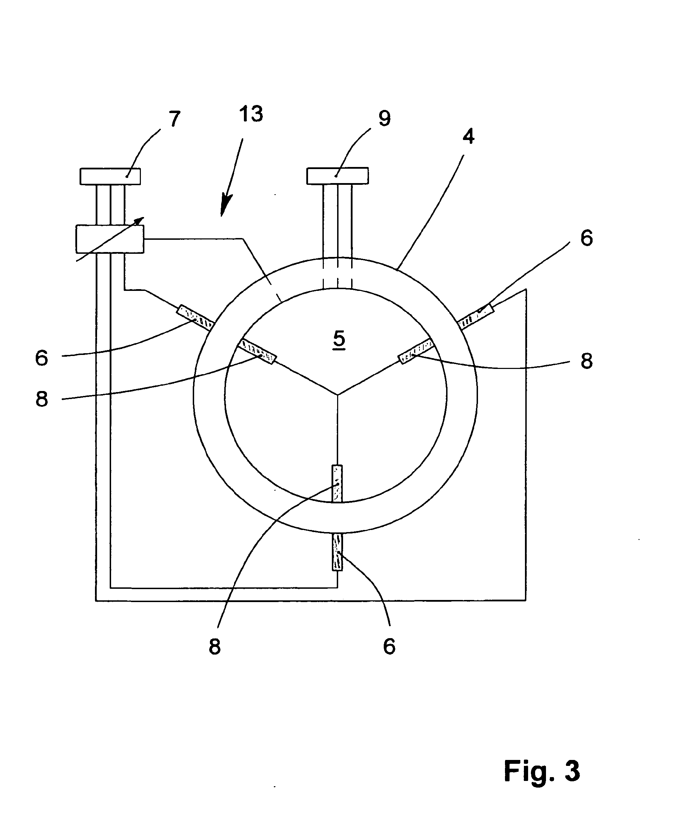

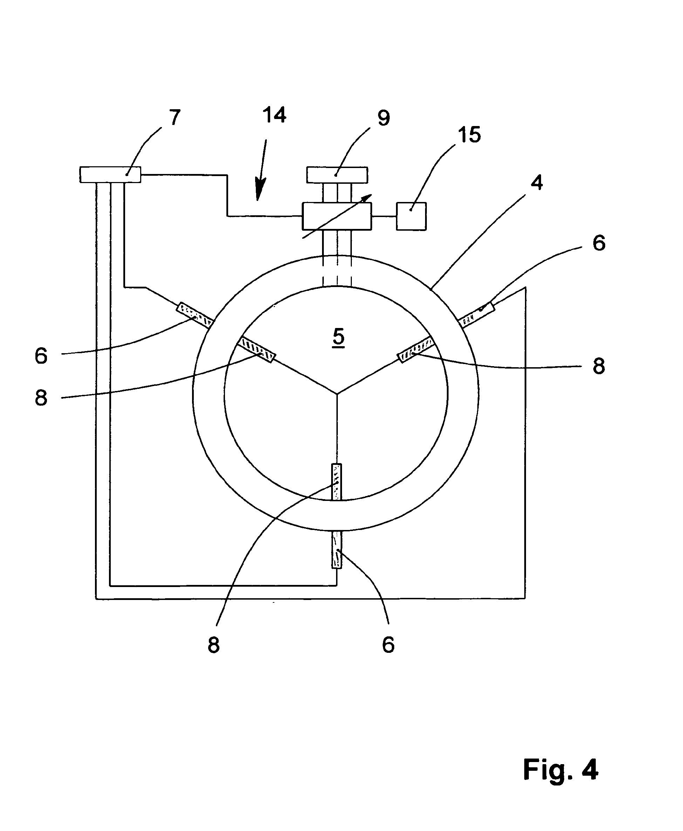

Dabei werden unterschiedliche Drehzahlen, die sich aus der Erregung des Stators 4 ergeben, prinzipiell dadurch realisiert, dass entweder:
- gemäß der **Fig. 3** über eine EMK-Reglung 13 die Stromstärke der an den elektrischen Wicklungen 6 des Stators 4 angelegten Wechselspannung geändert wird,
- gemäß der **Fig. 4** über eine Drehzahlregelung 14 die Stromstärke der an den elektrischen Wicklungen 8 des Rotors 5 angelegten Wechselspannung geändert wird oder
- gemäß der **Fig. 4** die Frequenz und die Amplitude der Erregung des Stators 4 als Führungsgröße für eine Drehzahlregelung 14 des Rotors 5 mit einer Datenschnittstelle 15 dienen, wobei am Rotor 5 diese Frequenz nachgeführt wird.

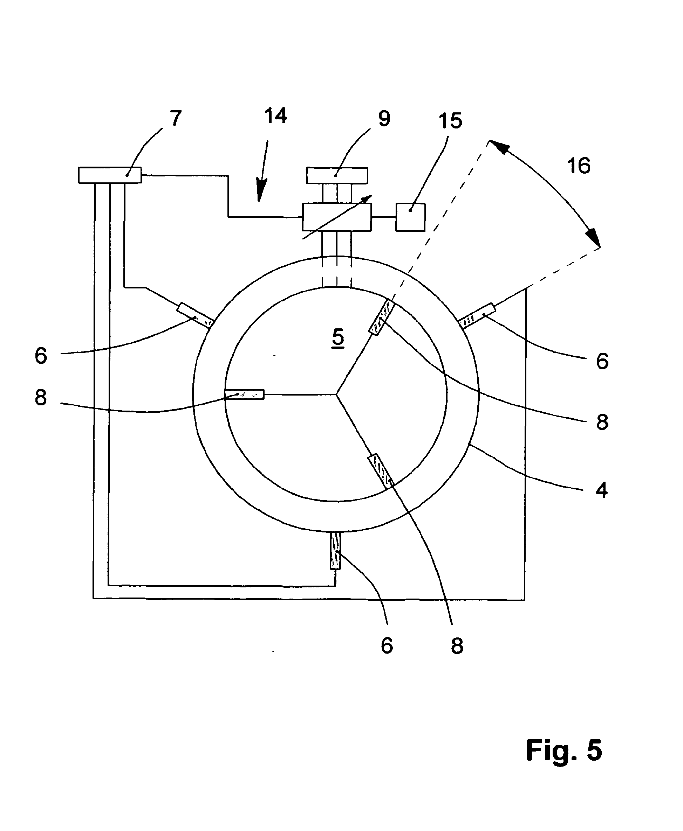

Danach ergibt sich gemäß der **Fig. 3** und der **Fig. 4** bei einer Änderung der Erregerfrequenz an den Wicklungen 6 des Stators 4, die an den Wicklungen 8 des Rotors 5 nachgeführt wird, eine Drehmoment-Drehzahl-Kennlinie. Aufgrund des Lastmomentes, welches dem Rotor 5 über die Datenschnittstelle 15 vorgegeben wird, stellt sich auf dieser Drehmoment-Drehzahl-Kennlinie eine Drehzahl ein, welche bei der Simulation eines Wechselstrommotors im Asynchronbetrieb gemäß der **Fig. 4** durch die Stromstärke an den Wicklungen 8 des Rotors 5 simuliert wird. Bei der Simulation eines Wechselstrommotors im Synchronbetrieb dagegen stellt sich auf der Drehmoment-Lastwinkel-Kennlinie ein Lastwinkel (16) ein, welche gemäß der **Fig. 5** durch unterschiedliche Phasenverschiebungen simuliert wird. Dabei ist der Lastwinkel 16, der auf die Drehachse des Rotors 5 bezogene Winkel zwischen den elektrischen Wicklungen 6 des Stators 4 und den elektrischen Wicklungen 8 des Rotors 5.

Außerdem wird durch die EMK-Reglung 13 die Wirkung einer Elektro-Motorischen-Kraft (EMK) eines originalen Elektromotors berücksichtigt. Dabei stellt sich bei der Simulation eines Wechselstrommotors durch den elektromechanischen Wandler 1 die Gegeninduktion des Rotors 5 in den Stator 4 als das Äquivalent zur EMK eines originalen Elektromotors ein. Die Gegeninduktion des Stators 4 in den Rotor 5 wird bei der Erregung des Rotors 5 durch den Umrichter 10 wie eine Spannungsquelle einbezogen. Der Energiefluss vom Stator 4 in den Rotor 5 durch die Gegeninduktion wird durch die EMK-Reglung 13 ausgeglichen, wobei es auch denkbar ist, die Regelung einer EMK nach Berechnungen eines Motormodells eines originalen Elektromotors zu realisieren. Bei der Simulation eines Wechselstrommotors im Asynchronbetrieb durch den elektromechanischen Wandler 1 ist es denkbar, die Gegeninduktion vom Stator 4 in den Rotor 5 als alleinige Spannungsquelle zu verwenden und die Amplitude über einen veränderbaren Widerstand einzustellen. Es ist denkbar, dass der elektromechanischen Wandler 1 über die EMK-Reglung 13 die dem Stator 4 bereitgestellte Energie um einen Betrag mindert, der bei einem originalen Asynchronmotor wie z.B. Asynchronmotor mit Kurzschlussläufer durch Haft-/Gleitreibung verloren geht.

Bei der Drehzahlregelung 14 werden Reibungsverluste eines originalen Elektromotors berücksichtigt. Dabei wird aus dem Antriebsmoment des elektromechanischen Wandlers 1 unter Vorgabe des Lastmoments von der Datenschnittstelle 15 die Drehzahl berechnet, wobei für einen Abbremsvorgang bei der Simulation eines Wechselstrommotors im Asynchronbetrieb sich die Amplitude seiner Erregung und damit das auf den Rotor 5 wirkende Drehmoment umkehrt, so dass beim Abbremsvorgang das vom elektromagnetischen Feld auf den Rotor 5 aufgebrachte Drehmoment entgegen der Drehrichtung des Rotors 5 gerichtet ist. Eine maximale Bremswirkung wird durch ein Vertauschen zweier Phasen der elektrischen Wicklungen 6 des Stators 4 erreicht, wodurch sich die Drehrichtung des elektromagnetischen Feldes der elektrischen Wicklungen 6 des Stators 4 in Bezug auf die Drehrichtung der elektrischen Wicklungen 8 des Rotors 5 genau umkehrt. Nach der Lenzschen Regel bedeutet das für die Erregung des Rotors 5, dass sich die Amplitude seiner Erregung ebenfalls umkehrt, so dass ein Drehmoment entgegen der Drehrichtung eines originalen Elektromotors aufgebaut wird.

Der Abbremsvorgang bei der Simulation eines Wechselstrommotors im Synchronbetrieb wird durch eine allmähliche Verringerung der Frequenz der Erregung am Stator 4 vorgegeben, wodurch das elektromagnetische Feld des Rotors 5 dem elektromagnetischen Feld des Stators 4 vorauseilt. Dadurch kehrt sich der Lastwinkel 16 um, so dass seine Richtung dann entgegengesetzt zur Richtung während des Beschleunigungsvorganges bei gleicher Erregung am Stator 4 ist.

In einer besonderen Anwendung der Vorrichtung zur Simulation eines elektromechanischen Wandlers nach der alternativen Ausführung des ersten Ausführungsbeispiels gemäß der **Fig. 2** sind die Frequenzen der an den elektrischen Wicklungen 6 des Stators 4 und an den elektrischen Wicklungen 8 des Rotors 5 angelegten Wechselspannungen zueinander verschieden, weil dadurch das Fehlverhalten und die Grenzsituationen eines realen Motors simulierbar sind. Dabei wird das Drehmoment des Rotors 5 über einen in der **Fig. 2** nicht dargestellten Drehmomentsensor oder die daraus resultierende Druckkraft z.B. über einen in der **Fig. 2** nicht dargestellten Federkraftmesser gemessen. Auch ist es denkbar, in der Anwendung der Vorrichtung zur Simulation von Elektromotoren nach der alternativen Ausführung des ersten Ausführungsbeispiels gemäß der **Fig. 2** die unterschiedlichen Lastfälle, anstelle durch unterschiedliche Lastwinkel 16 gemäß der **Fig. 5**, durch eine Phasenverschiebung zwischen der Frequenz des an den elektrischen Wicklungen 6 des Stators 4 anliegenden Wechselstromes und des an den elektrischen Wicklungen 8 des Rotors 5 anliegenden Wechselstromes durch Verstellen des Wechselstromes an den Wicklungen 8 des Rotors 5 zu simulieren.

Dabei ist es auch denkbar, die Simulation unterschiedlicher Lastfälle durch eine Phasenverschiebung der Frequenz des an den elektrischen Wicklungen 8 des Rotors 5 anliegenden Wechselstromes gegenüber dem an den elektrischen Wicklungen 6 des Stators 4 anliegenden Stromes durchzuführen und die Einstellung unterschiedlicher Lastwinkel 16 gemäß der **Fig. 5** zum Applizieren des elektronischen Wandlers 1, wie z.B. zur Parametrisierung, Justierung und Abstimmung einzusetzen.

Denkbar ist es auch, durch Verändern der Phasenverschiebung der Frequenz der an den elektrischen Wicklungen 8 des Rotors 5 anliegenden Wechselspannung das Drehmoment des Rotors 5 an ein vordefiniertes Drehmoment anzupassen.

Auch ist es denkbar, den Rotor 5 mit einem Wechselstrom zu speisen, dessen Frequenz gleich der Frequenz der Wechselstromerregung des Stators 4 ist, so dass die Amplitude der Erregung die Drehzahl simuliert.

Für die Simulation von Generatoren ist es denkbar, den Rotor 5 mit einem Wechselstrom zu speisen, wobei in einer ersten Variante der Stator 4 nicht erregt und die erzeugte elektrische Spannung im Stator 4 mit einem in den **Fig. 1** bis **Fig. 5** nicht dargestellten Spannungsmessgerät gemessen wird. In einer zweiten Variante wird dagegen auch der Stator 4 mit einem Wechselstrom erregt, wobei der Wechselstrom am Stator 4 gegenüber dem am Rotor 5 angelegten Wechselstrom die gleiche Frequenz und eine entgegengesetzte Amplitude aufweist.

Dabei ist es zum Erreichen einer möglichst genauen Simulation des Drehmomentes, welches das elektromagnetische Drehfeld des Luftspalts auf den Rotor 5 ausübt, auch denkbar, im Generatorbetrieb den Stator 4 und den Rotor 5 mit der jeweils gleichen Frequenz zu erregen und eine vom Stator 4 unabhängige Spannungsquelle nach den Berechnungen des Motormodells zu regeln und für die Simulation zur Verfügung zu stellen.

Auch ist es denkbar, zur Simulation eines Generators die Erregung des Rotors 5 gegenüber der Erregung des Rotors 5 bei der Motorsimulation zu erhöhen, so dass die vom Rotor 5 in den Stator 4 induzierte Spannung als Spannungsquelle am Stator 4 wirkt und diese mit einem in den **Fig. 1 bis Fig. 5** nicht dargestellten Spannungsmessgerät indirekt gemessen wird.

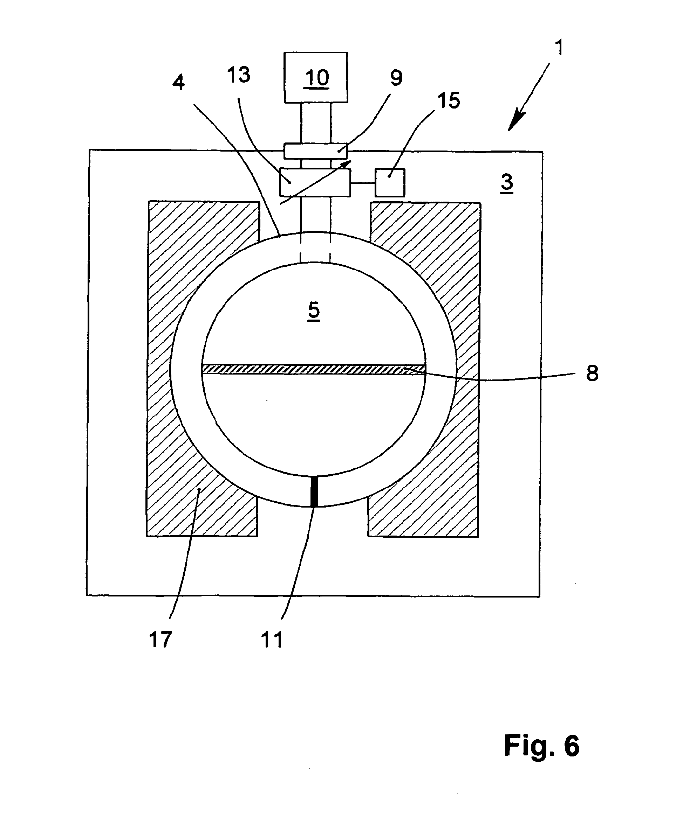

Die neue Vorrichtung zur Simulation eines elektromechanischen Wandlers besteht in einem zweiten Ausführungsbeispiel gemäß der **Fig. 6** im Wesentlichen aus dem elektromechanischen Wandler 1 und dem Umrichter 10, wobei der elektromechanische Wandler 1 wiederum das Gehäuse 3 sowie die in dem Gehäuse 3 angeordneten Stator 4 und Rotor 5 besitzt. Der Stator 4 weist einen Magneten 17 und der Rotor 5 eine elektrische Wicklung 8 auf, wobei der Magnet 17 ein Dauer- oder ein Elektromagnet ist. Die elektrische Wicklung 8 des Rotors 5 ist über die Drehzahlregelung 13 mit der Datenschnittstelle 15 und der Anschlussleiste 9 verbunden. Zudem ist der Rotor 5, ebenfalls wie im ersten Ausführungsbeispiel, über den Haltearm 11 derart mit dem Stator 4 des elektromechanischen Wandlers 1 verbunden, so dass der Rotor 5 gegenüber dem Stator 4 starr und nicht drehbar gelagert ist.

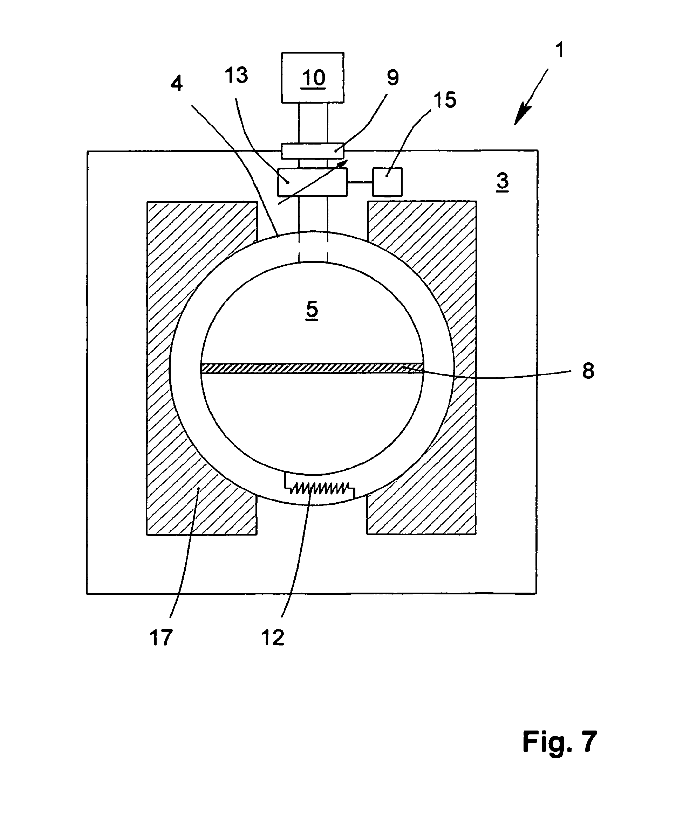

Alternativ ist gemäß der **Fig. 7** der Haltearm 11 durch die Spiralfeder 12 ersetzt, so dass der Rotor 5 des elektromechanischen Wandlers 1 sich verdrehen kann. Dabei wird durch die Spiralfeder 12 das durch das elektromagnetische Wechselfeld erzeugte und auf den Rotor 5 wirkende Drehmoment gemessen, wobei die Verdrehung des Rotors 5 ein Maß für das durch das elektromagnetische Wechselfeld erzeugte und auf den Rotor 5 wirkende Drehmoment ist. Dabei verändert diese Verdrehung das elektromagnetische Wechselfeld nicht.

Ist in dem zweiten Ausführungsbeispiel oder seiner Alternative der Magnet 17 ein Elektromagnet, so weist der Stator 4 in den **Fig. 6** und **Fig. 7** nicht dargestellte elektrische Wicklungen auf, die über eine, ebenfalls in den **Fig. 6** und **Fig. 7** nicht dargestellte EMK-Reglungen mit jeweils einem Anschlusskasten verbunden sind.

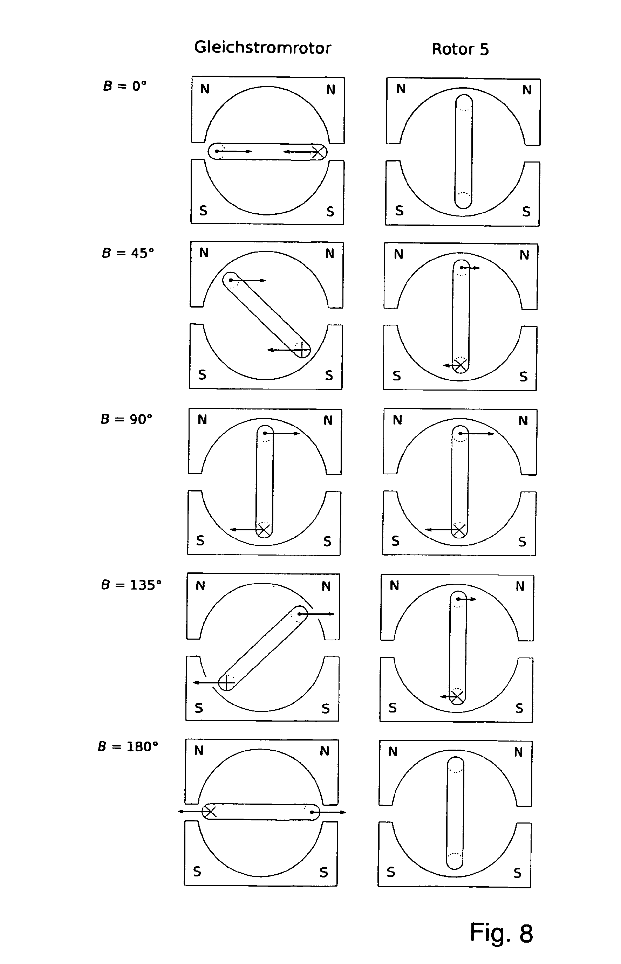

Die Wirkungsweise der neuen Vorrichtung zur Simulation eines elektromechanischen Wandlers nach dem zweiten Ausführungsbeispiel gemäß der **Fig. 6** soll beispielhaft an einem Simulationsablauf des Rotors 5 in einem Drehwinkel *β* von 0° bis 180° im Vergleich zu einem Gleichstromrotor gemäß der **Fig. 8** beschrieben werden.

Bei einem Winkel von 0° befindet sich der Gleichstromrotor in einer neutralen Zone, wobei beim Durchlaufen dieser neutralen Zone eine Umschaltung der Stromrichtung an der elektrischen Wicklung des Gleichstromrotors erfolgt und kein Drehmoment auf dem Gleichstromrotor wirkt. Dieser Zeitabschnitt wird mit dem Rotor 5 dadurch simuliert, dass kein Strom an der elektrischen Wicklung 8 anliegt, wobei die elektrische Wicklung 8 im Vergleich zu der elektrischen Wicklung des Gleichstromrotors um 90° in Drehrichtung des Gleichstromrotors verdreht ist.

Bei einem Winkel von 45° befindet sich der Gleichstromrotor in einer aktiven Zone, wobei auf dem Gleichstromrotor die Hälfte des maximalen Drehmoments wirkt. Dieser Zeitabschnitt wird mit dem Rotor 5 dadurch simuliert, dass die Hälfte des maximalen Stroms an der elektrischen Wicklung 8 anliegt, wobei die elektrische Wicklung 8 im Vergleich zu der elektrischen Wicklung des Gleichstromrotors um 45° in Drehrichtung des Gleichstromrotors verdreht ist.

Bei einem Winkel von 90° befindet sich der Gleichstromrotor ebenfalls in der aktiven Zone, wobei auf dem Gleichstromrotor das maximale Drehmoment wirkt. Dieser Zeitabschnitt wird mit dem Rotor 5 dadurch simuliert, dass der maximale Strom an der elektrischen Wicklung 8 anliegt, wobei auch auf dem Rotor 5 das maximale Drehmoment wirkt.

Bei einem Winkel von 135° befindet sich der Gleichstromrotor noch in der aktiven Zone, wobei auf dem Gleichstromrotor, wie bei einem Winkel von 45°, die Hälfte des maximalen Drehmoments wirkt. Dieser Zeitabschnitt wird mit dem Rotor 5 dadurch simuliert, dass wiederum die Hälfte des maximalen Stroms an der elektrischen Wicklung 8 anliegt, wobei die elektrische Wicklung 8 im Vergleich zu der elektrischen Wicklung des Gleichstromrotors um 45° entgegen der Drehrichtung des Gleichstromrotors verdreht ist.

Bei einem Winkel von 180° befindet sich der Gleichstromrotor wieder in der neutralen Zone, wobei beim Durchlaufen dieser neutralen Zone eine Umschaltung der Stromrichtung an der elektrischen Wicklung des Gleichstromrotors erfolgt und kein Drehmoment auf dem Gleichstromrotor wirkt. Dieser Zeitabschnitt wird mit dem Rotor 5 wiederum dadurch simuliert, dass kein Strom an der elektrischen Wicklung 8 anliegt, wobei die elektrische Wicklung 8 im Vergleich zu der elektrischen Wicklung des Gleichstromrotors vor dem Umschalten der Stromrichtung um 90° entgegen der Drehrichtung des Gleichstromrotors verdreht ist.

In dem Winkelbereich zwischen 180° bis 360° erfolgen die gleichen Schritte sowohl beim Gleichstromrotor als auch beim Rotor 5 wie im Winkelbereich zwischen 0 und 180°, wobei bei einem Winkel von 360° am Rotor 5 zwei identische positive Sinushalbwellen an der elektrischen Wicklung 8 anliegen.

In der Anwendung der Vorrichtung zur Simulation eines elektromechanischen Wandlers nach dem zweiten Ausführungsbeispiel gemäß der **Fig. 6** werden unterschiedliche Drehzahlen durch das Ändern der Periodendauer der an der elektrischen Wicklung 8 anliegenden positiven Sinushalbwellen und unterschiedliche Lastfälle durch das Ändern der Amplitude der an den elektrischen Wicklungen 8 des Rotors 5 angelegten positiven Sinushalbwellen erreicht.

Auch ist mit der Vorrichtung zur Simulation eines elektromechanischen Wandlers in der Alternative des zweiten Ausführungsbeispieles gemäß der **Fig. 7** das Drehmoment des Rotors 5 über die Spiralfeder 12 messbar, wobei alternativ das Drehmoment des Rotors 5 über einen Drehmomentsensor gemessen oder aus der mit einem Drucksensor gemessenen Druckkraft ermittelt werden kann.

Auch ist es denkbar, dass gemäß **Fig. 6** und **Fig. 7** nur der Effektivwert des am Rotor 5 angreifenden Momentes von Interesse ist. Dann könnte die elektrische Wicklung 8 des Rotors 5 auch unmittelbar mit einem Gleichstromwert, der dem Effektivwert zweier positiver Halbwellen entspricht, erregt werden.

Auch ist es denkbar, dass gemäß **Fig. 6** und **Fig. 7** sowohl die Wicklungen 6 des Stators 4 als auch die Wicklungen 8 des Rotors 5 mit einem Wechselstrom erregt werden. Die dabei wirkenden Kräfte zwischen Stator 4 und Rotor 5 sind, bezogen auf einem Zeitpunkt bzw. ein Zeitfenster, die gleichen wie bei einer Erregung mit Gleichstrom.

Mit einer entsprechenden Wechselstromerregung des Rotors 5 können somit auch Universalmotoren simuliert werden, wobei dann die Erregung des Rotors 5 mit der Wechselfrequenz des Stators 4 erfolgt und die Amplitude der Erregung die Drehzahl simulieren würde.

Denkbar ist es auch, wenn in dem zweiten Ausführungsbeispiel oder seiner Alternative der Magnet 17 ein Elektromagnet ist, den Rotor 5 mit einem Wechselstrom zu speisen, dessen Frequenz der Drehzahl eines realen Elektromotors entspricht, wenn der exakte Drehmomentenverlauf während einer Umdrehung von Interesse ist und mit einem Gleichstrom zu erregen, dessen Amplitude der Drehzahl eines realen Elektromotors entspricht, wenn nur der Effektivwert des Drehmomentenverlaufes während einer Umdrehung von Interesse ist.

**Liste der Bezugszeichen**
- 1: elektromechanischer Wandler
- 2: Umrichter
- 3: Gehäuse
- 4: Stator
- 5: Rotor
- 6: elektrische Wicklung
- 7: Anschlusskasten
- 8: elektrische Wicklung
- 9: Anschlussleiste
- 10: Umrichter
- 11: Haltearm
- 12: Spiralfeder
- 13: EMK-Regelung
- 14: Drehzahlregelung
- 15: Datenschnittstelle
- 16: Lastwinkel
- 17: Magnet

## Patentansprüche

1. Verfahren zur Simulation eines elektromechanischen Wandlers,
**dadurch gekennzeichnet, dass** bei einem elektromechanischen Wandler (1) für unterschiedliche Lastfälle das Verhalten eines realen Rotors simuliert wird, indem ein Spezialrotor (5) an seiner Rotation gehindert und separat mit einem elektrischen Strom erregt wird, so dass ein derartiges Magnetfeld um den Spezialrotor (5) läuft, welches einem Magnetfeld eines realen Rotors eines elektromechanischen Wandlers bei äquivalenter Drehzahl entspricht.

2. Verfahren nach Anspruch 1,
**dadurch gekennzeichnet, dass** unterschiedliche Drehzahlen simuliert werden durch:
- ein Ändern der Stromstärke der an den elektrischen Wicklungen (8) des Spezialrotors (5) angelegten Wechselspannung mittels einer Drehzahlreglung (14),
- ein Ändern der Stromstärke der an den elektrischen Wicklungen (6) des Stators (4) angelegten Wechselspannung mittels einer EMK-Reglung (13) oder
- eine Erregung eines Stators (4), wobei die Frequenz und die Amplitude dieser Erregung des Stators (4) als Führungsgröße für eine Drehzahlregelung (14) des Spezialrotors (5) dienen.

3. Verfahren nach Anspruch 2,
**dadurch gekennzeichnet, dass**:
a) im Asynchronbetrieb, während einer Änderung der Erregung an den Wicklungen (6) des Stators (4) eine Drehmoment-Drehzahl-Kennlinie bestimmt wird, wobei ein Lastmoment dem Spezialrotor (5) über eine Datenschnittstelle (15) vorgegeben wird, und sich auf dieser Kennlinie eine Drehzahl einstellt, welche bei der Simulation über die Drehzahlreglung (14) durch die Stromstärke an den Wicklungen (8) des Spezialrotors (5) simuliert wird oder
b) im Synchronbetrieb während einer Änderung der Erregung an den Wicklungen (6) des Stators (4) eine Drehmoment-Lastwinkel-Kennlinie bestimmt wird, wobei ein Lastmoment dem Spezialrotor (5) über eine Datenschnittstelle (15) vorgegeben wird, und sich auf dieser Kennlinie ein Lastwinkel (16) einstellt, welche bei der Simulation durch unterschiedliche Phasenverschiebungen simuliert wird.

4. Verfahren nach Anspruch 1,
**dadurch gekennzeichnet, dass**:
a) unterschiedliche Lastfälle durch:
- unterschiedliche Lastwinkel (16) simuliert werden, wobei ein Lastwinkel (16) der auf die Drehachse des Spezialrotors (5) bezogene Winkel zwischen den elektrischen Wicklungen (6) eines Stators (4) und den elektrischen Wicklungen (8) des Spezialrotors (5) ist oder
- eine Phasenverschiebung der an den elektrischen Wicklungen (8) des Spezialrotors (5) anliegenden Wechselspannung simuliert werden
und/ oder
b) das Drehmoment des Spezialrotors (5):
- über einen Drehmomentsensor gemessen oder
- aus einer aus dem Drehmoment resultierende, über einen Drucksensor oder einen Federkraftmesser gemessenen Druckkraft ermittelt wird.

5. Vorrichtung zur Simulation eines elektromechanischen Wandlers nach einem Verfahren der Ansprüche 1 bis 4, bestehend aus einem Gehäuse (3) mit einem in dem Gehäuse (3) angeordneten Stator (4) und einem Rotor,
**dadurch gekennzeichnet, dass** der Rotor ein Spezialrotor (5) ist, der:
- durch eine Haltevorrichtung gehalten und an seiner Rotation gehindert wird und
- drei über den Umfang des Spezialrotors (5) in einem Winkel von 120° verteilte elektrische Wicklungen (8) aufweist, wobei die elektrischen Wicklungen (8) des Spezialrotors (5) über eine Drehzahlregelung (14) einerseits mit einer Anschlussleiste (9) und andererseits mit einer Datenschnittstelle (15) elektrisch verbunden sind.

6. Vorrichtung nach Anspruch 5,
**dadurch gekennzeichnet, dass** die Haltevorrichtung:
- ein Haltearm (11) ist, durch den der Spezialrotor (5) derart gehalten wird, dass der Spezialrotor (5) gegenüber dem Stator (4) starr und nicht drehbar ist, wobei der Haltearm (11) direkt oder über einen Drucksensor mit dem Gehäuse (3) verbunden ist oder
- eine Spiralfeder (12) oder ein Drehmomentsensor ist, durch die der Spezialrotor (5) gegenüber dem Stator (4) schwenkbar ist.

7. Vorrichtung nach Anspruch 6,
**dadurch gekennzeichnet, dass**:
- der Stator (4) drei über den Umfang des Stators (4) in einem Winkel von 120° verteilte elektrische Wicklungen (6) aufweist und
- der Spezialrotor (5) drei über den Umfang des Spezialrotors (5) in einem Winkel von 120° verteilte elektrische Wicklungen (8) aufweist.

8. Vorrichtung nach Anspruch 7,
**dadurch gekennzeichnet, dass**:
a) für eine Drehzahlansteuerung die elektrischen Wicklungen (6) des Stators (4):
- mit einer EMK-Reglung (13) zum Ändern der Stromstärke einer an den elektrischen Wicklungen (6) des Stators (4) anliegenden Wechselspannungen elektrisch verbunden sind oder
- in einer Drehzahlregelung (14) mit einer Datenschnittstelle (15) integriert sind, wobei die Frequenz und die Amplitude der Erregung des Stators (4) als Führungsgröße für die Drehzahlregelung (14) des Spezialrotors (5) dienen,
und/ oder
b) für eine Lastfallsteuerung der Spezialrotor (5):
- mit einer Einrichtung zur Einstellung unterschiedliche Lastwinkel gekoppelt ist, wobei ein Lastwinkel (14) der auf die Drehachse des Spezialrotors (5) bezogene Winkel zwischen den elektrischen Wicklungen (6) des Stators (4) und den elektrischen Wicklungen (8) des Spezialrotors (5) ist oder
- mit einer Einrichtung zur Einstellung einer Phasenverschiebung der Frequenz der an den elektrischen Wicklungen (8) des Spezialrotors (5) anliegenden Wechselspannung gekoppelt ist.

9. Vorrichtung nach Anspruch 6,
**dadurch gekennzeichnet, dass** der Stator (4) einen Magneten (17) und der Spezialrotor (5) eine elektrische Wicklung (8) aufweist, wobei die elektrische Wicklung (8) des Spezialrotors (5) über eine Drehzahlregelung (14) einerseits mit einer Anschlussleiste (9) und andererseits mit einer Datenschnittstelle (15) elektrisch verbunden ist.

10. Vorrichtung nach Anspruch 9,
**dadurch gekennzeichnet, dass** der Magnet (17) ein Dauermagnet oder ein Elektromagnet ist.

## Claims

1. Method for simulation of an electromechanical converter,
**characterized in that**, at an electromechanical converter (1) the behaviour of a real rotor is simulated for different loading cases **in that** a special rotor (5) is prevented from rotating and is separately excited with an electrical current, so that, around the special rotor (5), there runs such a magnetic field, which corresponds to a magnetic field of a real rotor of an electromechanical converter at an equivalent rotational speed.

2. Method according to Claim 1,
**characterized in that** different rotational speeds are simulated by:
- changing the current intensity of the alternating voltage applied to the electrical windings (8) of the special rotor (5) by means of a rotational speed control (14),
- changing the current intensity of the alternating voltage applied to the electrical windings (6) of the stator (4) by means of an electromotive force control (13) or
- exciting a stator (4), the frequency and the amplitude of this excitation of the stator (4) serving as command variable for a rotational speed control (14) of the special rotor (5).

3. Method according to Claim 2,
**characterized in that**:
a) in asynchronous operation, during a change of the excitation on the windings (6) of the stator (4), a torque-rotational speed-characteristic curve is determined, a load torque being specified for the special rotor (5) via a data interface (15), and a rotational speed being established on the characteristic curve, which, in the simulation via the rotational speed control (14), is simulated by means of the current intensity on the windings (8) of the special rotor (5), or
b) in synchronous operation, during a change of the excitation on the windings (6) of the stator (4), a torque-load angle-characteristic curve is determined, a load torque being specified for the special rotor (5) via a data interface (15), and, on the characteristic curve, a load angle (16) being established, which, in the simulation, is simulated by means of different phase shifts.

4. Method according to Claim 1,
**characterized in that**:
a) different loading cases are simulated by means of:
- different load angles (16), a load angle (16) being the angle, measured at the rotational axis of the special rotor (5), between the electrical windings (6) of a stator (4) and the electrical windings (8) of the special rotor (5) or
- a phase shift of the alternating voltage present on the electrical windings (8) of the special rotor (5)
and/or
b) the torque of the special rotor (5) is:
- measured by means of a torque sensor or
- is determined by a pressure force, which results from the torque and is measured by means of a pressure sensor or a spring dynamometer.

5. Device for the simulation of an electromechanical converter according to a method of Claims 1 to 4, comprising a box (3) with a stator (4), which is disposed in the box (3), and a rotor,
**characterized in that** the rotor is a special rotor (5), which:
- is retained and prevented from rotating by means of a retaining means and
- comprises three electrical windings (8), which are distributed around the circumference of the special rotor (5) at an angle of 120°, the electrical windings (8) of the special rotor (5) being electrically connected, via a rotational speed control (14), to a connection strip (9) on the one hand and to a data interface (15) on the other hand.

6. Device according to Claim 5,
**characterized in that** the retaining means
- is a retaining arm (11), by means of which the special rotor (5) is held such that the special rotor (5) is rigid and non-rotatable with respect to the stator (4), the retaining arm (11) being connected, directly or via a pressure sensor, to the box (3), or
- a coil spring (12) or a torque sensor, by means of which the special rotor (5) can be pivoted with respect to the stator (4).

7. Device according to Claim 6,
**characterized in that**:
- the stator (4) comprises three electrical windings (6) which are distributed around the circumference of the stator (4) at an angle of 120° and
- the special rotor (5) comprises three electrical windings (8), which are distributed around the circumference of the special rotor (5) at an angle of 120°.

8. Device according to Claim 7,
**characterized in that**:
a) for rotational speed control, the electrical windings (6) of the stator (4):
- are connected to an electromotive force control (13) for changing the current intensity of an alternating voltage present on the electrical windings (6) of the stator (4) or
- are integrated in a rotational speed control (14) with a data interface (15), the frequency and the amplitude of this excitation of the stator (4) serving as command variable for the rotational speed control (14) of the special rotor (5),
and/or
b) for load-dependent control, the special rotor (5):
- is coupled to a device for setting different load angles, a load angle (16) being the angle, measured at the rotational axis of the special rotor (5), between the electrical windings (6) of the stator (4) and the electrical windings (8) of the special rotor (5), or
- is coupled to a device for setting a phase shift of the frequency of the alternating voltage which is present on the electrical windings (8) of the special rotor (5).

9. Device according to Claim 6,
**characterized in that** the stator (4) comprises a magnet (17) and the special rotor (5) comprises an electrical winding (8), the electrical winding (8) of the special rotor (5) being electrically connected, via a rotational speed control (14), to a connector strip (9) on the one hand and to a data interface (15) on the other hand.

10. Device according to Claim 9,
**characterized in that** the magnet (17) is a permanent magnet or an electromagnet.

## Revendications

1. Procédé de simulation d'un convertisseur électromécanique,
**caractérisé en ce que** chez un convertisseur électromécanique (1) le comportement d'un rotor réel est simulé pour différents cas de charge, en empêchant la rotation d'un rotor spécial (5) et en l'excitant séparément avec un courant électrique, de sorte qu'un champ magnétique circule autour du rotor spécial (5), de type tel qu'il correspond à un champ magnétique d'un rotor réel d'un convertisseur électromécanique à vitesse de rotation équivalente.

2. Procédé selon la revendication 1,
**caractérisé en ce que** différentes vitesses de rotation sont simulées par:
- une modification de l'intensité de courant de la tension alternative appliquée sur les bobines électriques (8) du rotor spécial (5) au moyen d'une régulation de vitesse de rotation (14),
- une modification de l'intensité de courant de la tension alternative appliquée sur les bobines électriques (6) du stator (4) au moyen d'une régulation à force électromotrice (13) ou
- une excitation d'un stator (4), la fréquence et l'amplitude de cette excitation du stator (4) servant de grandeur de référence pour une régulation de la vitesse de rotation (14) du rotor spécial (5).

3. Procédé selon la revendication 2,
**caractérisé en ce que** :
a) au fonctionnement asynchrone, pendant une modification de l'excitation sur les bobines (6) du stator (4), une courbe caractéristique couple-vitesse de rotation est déterminée, un couple résistant étant prescrit au rotor spécial (5) via une interface de données (15), et une vitesse de rotation s'adaptant à cette courbe caractéristique, qui est simulée par l'intensité de courant sur les bobines (8) du rotor spécial (5) lors de la simulation via la régulation de la vitesse de rotation (14) ou
b) au fonctionnement synchrone, pendant une modification de l'excitation sur les bobines (6) du stator (4), une courbe caractéristique couple-angle de charge est déterminée, un couple résistant étant prescrit au rotor spécial (5) via une interface de données (15), et un angle de charge(16) s'adaptant à cette courbe caractéristique, qui est simulé par différents décalages de phase lors de la simulation.

4. Procédé selon la revendication 1,
**caractérisé en ce que** :
a) différents cas de charge :
- sont simulés par différents angles de charge (16), un angle de charge (16) étant l'angle se référant à l'axe de rotation du rotor spécial (5) entre les bobines électriques (6) d'un stator (4) et les bobines électriques (8) du rotor spécial (5) ou
- sont simulés par un décalage de phase de la tension alternative appliquée sur les bobines électriques (8) du rotor spécial (5)
et/ou
b) le couple du rotor spécial (5) :
- est mesuré via un détecteur de couple ou
- est calculé à partir d'une force de compression résultant du couple, mesurée via un capteur de pression ou un mesureur d'élasticité.

5. Dispositif de simulation d'un convertisseur électromécanique selon un procédé des revendications 1 à 4, se composant d'un coffret (3) avec un stator (4) et un rotor disposés dans le coffret (3),
**caractérisé en ce que** le rotor est un rotor spécial (5), qui :
- est maintenu par un dispositif de retenue et empêché d'effectuer sa rotation et
- présente trois bobines électriques (8) réparties sur la circonférence du rotor spécial (5) dans un angle de 120°, les bobines électriques (8) du rotor spécial (5) étant reliées électriquement via une régulation de vitesse de rotation (14) d'une part à une réglette de raccordement (9) et d'autre part à une interface de données (15).

6. Dispositif selon la revendication 5,
**caractérisé en ce que** le dispositif de retenue :
- est un bras de support (11), par lequel le rotor spécial (5) est maintenu de sorte que le rotor spécial (5) soit rigide et non tournant par rapport au stator (4), le bras de support (11) étant relié directement ou via un capteur de pression au coffret (3) ou
- est un ressort en spirale (12) ou un capteur de couple, par lequel le rotor spécial (5) est pivotant par rapport au stator (4).

7. Dispositif selon la revendication 6,
**caractérisé en ce que** :
- le stator (4) présente trois bobines électriques (6) réparties sur la circonférence du stator (4) dans un angle de 120° et
- le rotor spécial (5) présente trois bobines électriques (8) réparties sur la circonférence du rotor spécial (5) dans un angle de 120°.

8. Dispositif selon la revendication 7,
**caractérisé en ce que** :
a) pour une excitation de la vitesse de rotation, les bobines électriques (6) du stator (4) :
- sont reliées électriquement à une régulation à force électromotrice (13) pour modifier l'intensité de courant d'une tension alternative appliquée sur les bobines électriques (6) du stator (4) ou
- sont intégrées dans une régulation de vitesse de rotation (14) avec une interface de données (15), la fréquence et l'amplitude de l'excitation du stator (4) servant comme grandeur de référence pour la régulation de la vitesse de rotation (14) du rotor spécial (5),
et/ou
b) pour une commande du cas de charge, le rotor spécial (5) :
- est accouplé à un dispositif pour le réglage d'angles de charge différents, un angle de charge (16) étant l'angle se référant à l'axe de rotation du rotor spécial (5) entre les bobines électriques (6) du stator (4) et les bobines électriques (8) du rotor spécial (5) ou
- est accouplé à un dispositif pour le réglage d'un décalage de phase de la fréquence de la tension alternative appliquée sur les bobines électriques (8) du rotor spécial (5).

9. Dispositif selon la revendication 6,
**caractérisé en ce que** le stator (4) présente un aimant (17) et le rotor spécial (5) une bobine électrique (8), la bobine électrique (8) du rotor spécial (5) étant reliée électriquement via une régulation de vitesse de rotation (14) d'une part à une réglette de raccordement (9) et d'autre part à une interface de données (15).

10. Dispositif selon la revendication 9,
**caractérisé en ce que** l'aimant (17) est un aimant permanent ou un électroaimant.
